# EUROPEAN PATENT APPLICATION

(11) **EP 2 404 867 A1**
(43) Date of publication of application: **11.01.2012**
(21) Application number: 10169186.3
(22) Date of filing: 09.07.2010
(51) Int. Cl.: B81C 1/00, B01L 3/00

(54) **Method for preparing microfluidic devices**

(71) Applicant: Trinean NV, 9050 Gentbrugge (BE)
(72) Inventor: Naessens, Kris, 9090 Melle (BE); Montoye, Tony, 9031 Drongen (BE)
(74) Representative: Hertoghe, Kris Angèle Louisa

(57) **Abstract**

The present invention relates to a method for obtaining a hydrophilic effect in a microfluidics device. A microfluidics device is first obtained (20), comprising a channel for transporting fluid from an entrance towards an exit. The obtained microfluidics device then is subjected to an activation treatment (40), such as for example local plasma treatment, for selectively increasing the surface energy of part of the walls of the channel at those positions where a hydrophilic effect is desirable. Thereafter a coating is selectively applied (50) on selected parts of the walls of the channel by providing a predetermined amount of wetting agent in the channel.

## Description

### Field of the invention

The invention relates to the field of microfluidics characterisation. More particularly the present invention relates to methods and systems for preparing microfluidics devices and devices thus obtained.

### Background of the invention

Characterisation of microfluidics is used in a wide variety of applications, such as for example in the field of biology, biotechnology, chemistry and for clinical and medical purposes. One of the requirements posed in the majority of these applications is the need for automatically transporting fluid samples or holding samples at specific positions.

In some applications, pumping means are used for transporting the sample fluid in the device. In some other applications automatic transporting of the sample fluid is used, e.g. based on gravity or capillary force.

Microfluidics devices exist wherein the walls of the channels are coated with a hydrophilic coating resulting in a lower contact angle of the fluid with the channel surface and consequently an increased capillary force, thus rendering automatic filling easier. Different types of applying a surface treatment for inducing a hydrophilic effect exist, such as for example topical application of a surfactant, plasma treatment, vacuum deposition, polymerization of hydrophilic monomers, grafting hydrophilic moieties onto the film surface, corona or flame treatment, etc.

### Summary of the invention

It is an object of embodiments of the present invention to provide good methods for preparing microfluidics devices and/or to provide microfluidics devices thus obtained.

It is an advantage of embodiments according to the present invention that the walls of the microfluidics device can be made hydrophilic.

It is an advantage of embodiments according to the present invention that the walls of the microfluidics device can be made strongly hydrophilic.

It is an advantage of embodiments according to the present invention that the location of the hydrophilic coating can be controlled, allowing a more accurate use of the microfluidics device.

It is an advantage of embodiments according to the present invention that accurate spontaneous transfer of fluid can be obtained to predetermined positions in the microfluidics device, while no further spontaneous transfer of the fluid occurs.

It is an advantage of embodiments according to the present invention that local application of a hydrophilic treatment can be applied so that unwanted condensation, e.g. on windows in a measurement chamber, can be reduced or avoided.

It is an advantage of embodiments according to the present invention that a hydrophilic effect with long lifetime can be created in the microfluidics device, prolonging the possible on the shelf lifetime.

It is an advantage of embodiments according to the present invention that the amount of fluid that is transported in the microfluidics device can be determined based on the localisation of the hydrophilic treatment.

The above object is obtained by a method and device according to embodiments of the present invention.

The present invention relates to a method for obtaining a hydrophilic effect in a microfluidics device, the method comprising obtaining a microfluidics device comprising a channel for transporting fluid from an entrance towards an exit, providing an activation treatment to the obtained microfluidics device for increasing the surface energy of at least part of the walls of the channel at least at those positions where a hydrophilic effect is desirable, and thereafter selectively applying a coating on selected parts of the walls of the channel by providing a predetermined amount of hydrophilic agent in the channel. It is an advantage of embodiments according to the present invention that a stable hydrophilic effect can be obtained on a selected portion of the flow path of the fluid in the microfluidics device. It is an advantage of embodiments of the present invention that the selected portion can be accurately defined and that induction of hydrophilic effects at places where it is not desired can be avoided, resulting in a more accurate operation of the microfluidics device, e.g. of fluidic stops operating therein. Obtaining a microfluidic device may comprise obtaining a microfluidics device comprising a closed channel for transporting fluid from an entrance towards an exit.

Providing an activation treatment may comprise applying plasma treatment, such as for example plasma activation and/or plasma etching.

Applying plasma treatment may comprise locally applying plasma treatment for selectively increasing the surface energy of part of the walls of a channel.

Locally applying plasma treatment may comprise applying plasma activation and/or etching to the channel via the entrance and/or exit of the microfluidics channel. In one embodiment, the penetration of the plasma at the entrance side determines what the entrance depth will be over which the wetting agent can be easily introduced. It is an advantage of embodiments of the present invention that all walls of the channel, i.e. side walls, top wall and bottom wall, can be provided with a hydrophilic effect, resulting in a still more accurate operation of the microfluidics device.

Applying plasma treatment may comprise applying an oxygen plasma etch. Providing an activation treatment may comprise irradiating the device using UV radiation. Providing a predetermined amount of hydrophilic agent in the channel may comprise providing a polymer coating having a hydrophilic portion. The polymer coating may comprise ethylene oxide. It is an advantage of embodiments of the present invention that the combination of a plasma treatment, e.g. plasma etch, and the use of ethylene oxide as hydrophilic agent results in device having a stable hydrophilic effect in the part of the channel where it is required. The polymer coating may comprise block copolymers based on ethylene oxide and propylene oxide. The part of the walls where a hydrophilic effect is desirable may comprise at least the entrance of the channel and a storage chamber for storing the fluidic sample before measurement. It is an advantage of embodiments according to the present invention that accurate and complete filling of the storage room may be obtained using the stable and accurate hydrophilic effect as can be induced using an embodiment of the present invention. Obtaining a microfluidics device having a closed channel for transporting fluids from an entrance to an exit channel may comprise obtaining a moulded, embossed or casted first microfluidics device substrate forming at least a first part of the channel and providing a top lid on the first microfluidics device substrate for closing the channel so as to form a closed channel.

The present invention also relates to a microfluidics device for characterising a fluid sample, the microfluidics device comprising a channel for transporting fluid from an entrance towards an exit, the channel being provided with a hydrophilic coating on selected parts of the walls of the channel using a method as described above. The channel may be a closed channel.

Particular and advantageous aspects of some embodiments of the invention are set out in the accompanying dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter. Embodiments of the present invention lead to improved characterisation of microfluidics.

### Brief description of the drawings

FIG. 1 shows a flow chart of an exemplary method for obtaining a hydrophilic effect on a selected part of a microfluidics device, according to an embodiment of the present invention.
FIG. 2a and FIG. 2b schematically illustrates a number of steps of an exemplary method for obtaining a hydrophilic effect on a selected part of a microfluidics device, according to an embodiment of the present invention.
FIG. 3 illustrates a microfluidics device according to an embodiment of the present invention, wherein a hydrophilic coating is applied to a selected part of the device.
FIG. 4 illustrates a comparison of microfluidic devices filling for microfluidic devices made using a local hydrophilic coating treatment according to embodiments of the present invention and a non-local hydrophilic coating treatment wherein only plasma treatment is applied for making part of the device hydrophilic.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

### Detailed description of illustrative embodiments

While the invention will be illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single unit may fulfill the functions of several items recited in the claims. The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

Where in embodiments of the present invention reference is made to plasma treatment, reference may be made to plasma etching and/or plasma activation, i.e. creation of radicals at the surface treated using a plasma.

Where in embodiments of the present invention reference is made to a wall having increased surface energy or to the step of increasing the surface energy, reference is made to activated walls or activation of the walls by providing a higher surface energy, compared to non-treated walls. Treated walls thereby may also be referred to as activated walls, and may be treated or activated using plasma treatment, UV radiation, etc.

Where in embodiments of the present invention reference is made to a coating this also encompasses application of a layer, application of a film, etc. In other words, the terminology coating, film, layer, etc. may be used for referring to addition of material to or onto a wall of the microfluidics device.

Where in embodiments of the present invention reference is made to a wetting agent, the latter encompasses a hydrophilic material, a detergent, an amphiphilic material, etc. In some embodiments, the wetting agents thus may advantageously be hydrophilic agents.

Where in embodiments of the present invention reference is made to a microfluidics device, reference is made to a device for characterising a microfluidic sample, the device comprising at least one channel for transporting the sample in a substrate. Embodiments of the present invention are not limited by the volume of the microfluidics device and the corresponding volume of sample that can be measured, but embodiments of the present invention are especially advantageous where accuracy is to be high, such as for example in case small volumes of fluid need to be studied. With small volumes there may be meant between 0.2µl and 7µl, advantageously between 1µl and 5µl, more advantageously between 1µl and 3.5µl. Characterisation of microfluidic samples may comprise detection of the presence of certain components, determination of concentration of certain components, determination of certain reactions occurring, etc. Such characterisation may include for example applications in the field of biology, biotechnology, chemistry, the clinical field and/or the medical field. Where in some embodiments of the present invention reference is made to a closed channel, reference is made to a channel having an entrance for entry of the fluid, an exit for removing the fluid, the channel further being surrounded by walls, i.e. closed, at all sides, more particularly comprising side walls, a bottom wall and a top wall. This is e.g. in contrast with an open channel where besides an entrance and exit also a top wall is missing.

In a first aspect, the present invention relates to a method for obtaining a hydrophilic effect in a microfluidics device. A microfluidics device comprising a channel for transporting fluids from an entrance towards an exit is obtained. In some embodiments, a microfluidic device is obtained wherein the channel is a closed channel. The microfluidics device may comprise further chambers and/or features, such as for example fluidic stops, measurement chambers, vents, reaction chambers, mixing chambers, etc. which may be located in part of the channel or which may be further downstream in the micro-fluidic device. For obtaining the hydrophilic effect, the method according to embodiments of the present invention comprises a first step of applying an activation treatment for increasing the surface energy of at least part of the walls of the channel at at least those positions where a hydrophilic coating is required. The activation treatment advantageously in some embodiments may be plasma treatment. Nevertheless embodiments of the present invention are not limited thereto and for example irradiating using UV radiation also may be performed. The method furthermore comprises a second step, after said activation treatment , being selectively applying a coating on selected parts of the walls of the channel by providing a predetermined amount of wetting agent in the channel. The wetting agent may in some embodiments be applied by filling the channel with the predetermined amount of wetting agent from an inlet, such that for example the initial part of the path downstream is hydrophilic coated, e.g. for inducing automated filling. Obtaining the hydrophilic effect through a two steps process wherein first an activation treatment is performed, e.g. plasma treatment like plasma etching, and thereafter providing a predetermined amount of wetting agent is advantageous as it allows accurate filling with the predetermined amount of wetting agent and through selection of the appropriate predetermined amount, accurately determining which part of the walls will be provided with a stable hydrophilic coating. The activation treatment as such thereby does not result in a stable hydrophilic coating but advantageously assists in the filling of the channel with wetting agent. The activation treatment thus advantageously assists self-filling of the wetting agent in the channel, so the complete or almost complete predetermined amount of wetting agent will be sucked into the channel.

According to some embodiments, applying an activation treatment for increasing the surface energy of the walls may be performed locally, i.e. substantially only at positions where in the end a hydrophilic coating is to be present. Nevertheless, in combination with a local application of the coating via insertion of a predetermined amount of wetting agent in the channel, also a general activation treatment upfront may result in good stability and accurate positioning of the final hydrophilic coating. If general activation treatment is performed upfront, advantageously, the lifetime of the increased surface energy is selected to be short, so that the hydrophilic properties are in the long term determined by the parts subject to selective application of the coating through providing the wetting agent in the channel and not by all the parts that were subject to the activation treatment.

The method thus results in a hydrophilic coating being present in part of the channel, e.g. on all walls of the channel up to one point downstream the channel. The obtained hydrophilic coating is advantageous as it has a good stability and can be accurately positioned.

It furthermore has been found that the hydrophilic coating can be accurately limited to those regions where it should be present, for example not further downstream than intended. This region is defined by the amount of wetting agent that is dispensed in the inlet and thus the channel volume it can fill. It has been found that a good uniformity is obtained for the hydrophilic coating.

It is an advantage of some embodiments according to the present invention that the activation treating as well as coating is performed on a device comprising a closed channel, allowing that for a selected part of a channel, all walls can be coated.

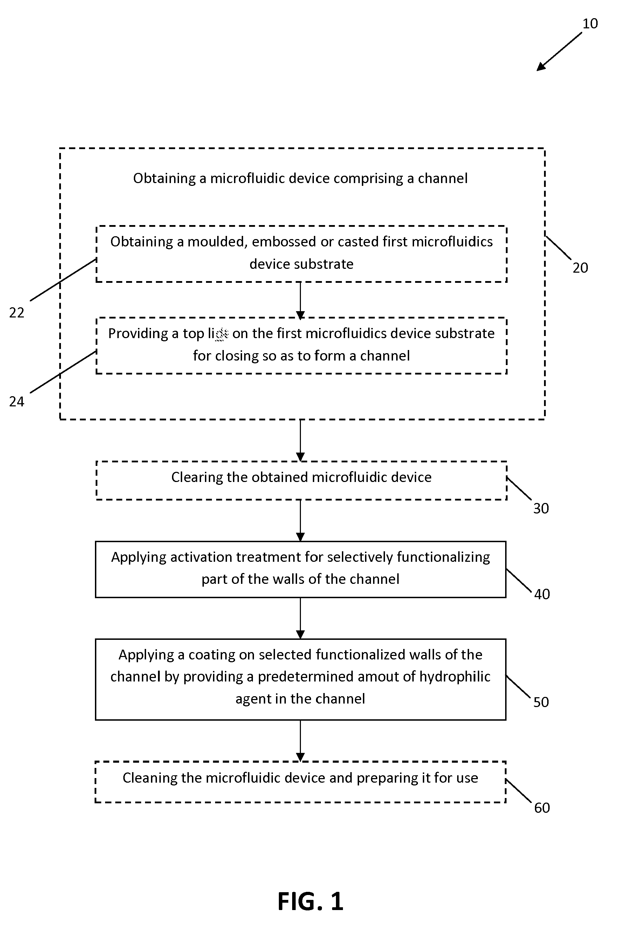

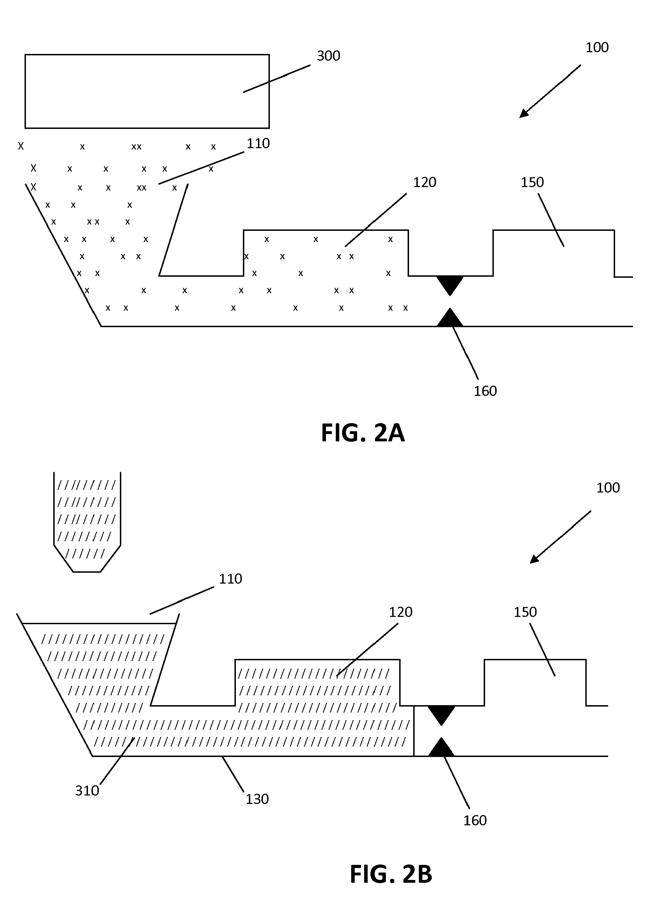

By way of illustration, embodiments of the present invention not being limited thereto, an exemplary method for providing a hydrophilic effect in a microfluidics device is discussed below, indicating standard and optional steps. The exemplary method is described with reference to the preferred activation treatment plasma treatment, e.g. plasma etching, although embodiments of the present invention are not limited thereto, and can mutatis mutandis be applied with UV radiation as activation treatment step. In FIG. 1 a flow chart indicating such standard steps and optional steps of an exemplary method 10 for providing a hydrophilic effect in a microfluidics device. Reference is also made to FIG. 2a and FIG. 2b, illustrating some steps of an exemplary method for obtaining a hydrophilic effect.

In a first optional step, the method comprises obtaining 20 a microfluidics device comprising a closed channel. Such a closed channel comprises an entrance for entry of the fluid sample and an exit for removing the fluid sample and further is adapted for transporting a fluid sample, whereby the channel at all other sides is surrounded by walls. Obtaining a microfluidics device may encompass either buying an off the shelf microfluidics device, or manufacturing such a microfluidics device. According to embodiments of the present invention, the microfluidic device may be made in any suitable way, such as for example by spray casting, milling, moulding, laminating, thermoforming, embossing, etc. or a combination thereof. The microfluidic device may be made of any suitable material, such as for example polymers, glass, quartz, silicon, gels, plastics, resins, carbon, metals, etc. In some examples Cyclic Olefin Copolymers (COC), Cyclic Olefin Polymers (COP), polycarbonate, acrylate, polypropylene, SU-8, etc. can be used. The manufacturing in some embodiments could comprise a step of obtaining 22 a moulded, embossed or casted first microfluidics device substrate, and the step of providing 24 a top lid on the first microfluidics device substrate for closing the microfluidics device and for forming a closed channel.

In a second optional step 30, the method optionally may comprise cleaning the obtained microfluidics device, e.g. for removing unwanted residues induced by the manufacturing process.

In a first essential step according to embodiments of the present invention, the method comprises providing an activation treatment for increasing the surface energy of the walls in the channel, e.g. applying plasma treatment like plasma etching to the walls of the channel. The plasma treatment such as e.g. plasma etching, may be local or general. In advantageous embodiments, the plasma treatment, e.g. plasma etching may be applied locally. The part of the walls of the closed channel may be all of the walls of the closed channel upstream a given point in the microfluidics device. It is to be noticed that the transition point between activated walls and not-activated walls may be a transition region wherein the transition is gradually. The transition region nevertheless is substantially smaller than the region with activated walls. Locally applying plasma treatment, e.g. plasma etching may result in selectively increasing the surface energy of that part of the walls. Locally applying plasma treatment, e.g. plasma etching according to embodiments of the present invention is performed after the microfluidics device has been closed using a top lid. In this way a closed channel can be formed and the plasma treatment, e.g. plasma etching, can be applied, if desired, to all walls of the channel. Different types of plasma treatment can be used such as for example plasma etching or plasma activation based on oxygen, air, nitrogen, argon, or other gases. In one advantageous embodiment, oxygen plasma etching is performed. The plasma treatment results in a surface modification, also referred to as surface-activation that turns the walls hydrophilic. For example, in case of 02 plasma, atomic oxygen hits the walls and leaves broken chemical bonds on the surface. Surface radicals make the walls hydrophilic. As these radicals react easily with the atmosphere, the activation of the wall is neutralised through reaction with components in the atmosphere, resulting in the effect being temporary. Alternatively, UV light and/or radiation can also be used for creating such surface radicals. By way of illustration, the processing step wherein applying plasma treatment is performed is shown in FIG. 2a, embodiments of the present invention not being limited hereby. In FIG. 2a a microfluidics device 100 with input well 110, closed channel 120, measurement chamber 150 and fluidic stop 160 is illustrated. Furthermore a plasma generating means 300 or plasma generator is provided allowing to provide a plasma that, in the present example, can enter the microfluidics device to a given depth downstream the closed channel. The depth may be determined by the energy of the plasma particles, the type of particles, the vacuum pressure in the plasma system, amount of generated plasma radicals, duration of the treatment, etc.

After the application of the plasma treatment, embodiments of the present invention also include a second essential step of applying a hydrophilic coating to selected walls 130 having an increased surface energy by providing a predetermined amount of wetting agent in the channel. In other words, a wetting agent in solution is provided in the channel in a predetermined volume, such that the part of the channel that is to be provided with a wetting agent on the walls is filled with the solution. The wetting agent then interacts with the walls of the channel having an increased surface energy and forms a hydrophilic coating on the walls. The channel may be a closed channel. When applying the activation treatment locally, three possible situations can occur : (A) the activation treatment is applied locally such that it corresponds with the depth of the hydrophilic coating determined by the amount of wetting agent used (as shown in FIG. 2B); (B) the activation treatment is applied locally such that only part of the walls that need to be covered with hydrophilic coating by the wetting agent is increased in surface energy by the activation treatment resulting in a slower filling for the part of the walls not having an increased surface energy; (C) the activation treatment is applied locally such that more walls have an increased surface energy than those that need to be provided with a hydrophilic coating which will in the end result in a hydrophilic effect of the walls determined by the amount of wetting agent used because the temporary hydrophilic effect induced by the activation treatment as such is not stable and disappears. By way of illustration, the processing step wherein providing locally a hydrophilic coating is performed in shown in FIG. 2B. Typical materials that may be used as wetting agent are polymer coatings having a hydrophilic portion, such as for example polymers comprising ethylene oxide, such as for example polyethylene oxide, polyethylene glycol, etc. The hydrophilic coating may for example be a hydrophilic polymer, like for example, polyalkylene glycols and alkoxy polyalkylene glycols; copolymers of methylvinyl ether and maleic acid; maleic anhydride polymers; polylkylene oxides, such as the polyethylene oxides; poly((meth)acrylic acids); polymers of hydroxyl-substituted lower alkyl(meth)acrylates, such 2-hydroxyalkyl(meth)acrylate; polyvinylalcohols, hydrophilic polyamides; poly(meth)acrylamides; poly(N-isopoly(meth)acrylamides); poly(sodium-4-styrenesulfonates) and poly(sodium vinylsulfonates); poly(3-hydroxybutyric acids); poly(N-vinyl lactams) such as the polyvinylpyrrolidones; hydrophilic polyurethanes; polyethyleneimines; poly(sodium(meth)acrylates); methyl cellulose, hydroxylmethyl cellulose, hydroxyethyl cellulose; polyvinylsulfonic acid; heparin; dextran and dextan sulfate and other modified dextrans; poly(saccharides); chondroitin sulphate; lecithin; poloxamer; as well as mixtures and copolymers thereof. In some embodiments, the coating may be formed by evaporating the solvent in the solution. In other embodiments, the wetting agent interacts with the walls, i.e. the walls having an increased surface energy, and binds thereto, so that upon removal of the fluid, e.g. through pumping or evaporation, a hydrophilic coating remains.

The combination of locally applying plasma treatment and applying a hydrophilic coating results in an advantageously stable, uniform and accurately positioned hydrophilic effect in the microfluidics device that can be accurately restricted to certain areas of the device, that has a long on the shelf life time, and has good uniformity.

In a further optional step, the microfluidics device is cleaned for removing remaining parts of the hydrophilisation process and/or further prepared for use, e.g. by introducing reactants etc.

An advantage of embodiments according to the present invention is that the provision of a predetermined amount of wetting agent can provide a check of the functioning of the microfluidic device. By applying the wetting agent and checking the filling behaviour of the wetting agent, it can be checked whether or not blocking of fluid flow is present due to irregularities in the chip, even when this blocking is positioned further downstream, where no wetting agent is applied. The latter is in particular of interest for microchips wherein the hydrophilic coating steps are performed on a closed channel microfluidic device.

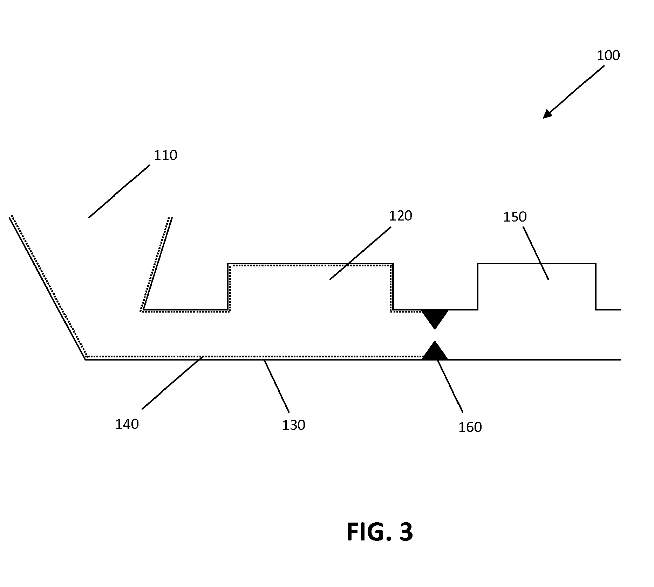

In a second aspect, the present invention relates to a microfluidics device for characterising a fluid sample. The microfluidics device according to embodiments of the present invention comprises a closed channel for transporting fluid from an entrance to an exit, whereby the closed channel is provided with a hydrophilic coating on selected parts of the walls of the closed channel. The hydrophilic coating thereby is obtained using at least a two-step method according to the first aspect. By way of illustration, embodiments of the present invention not being limited thereto, an example of a microfluidics device is illustrated in FIG. 3.

FIG. 3 illustrates a microfluidics device 100 comprising an input well 110 for loading the fluid sample to be characterised. The input well 110 may be shaped such that it can receive the sample fluid. The microfluidics device 100 of the present example comprises a closed channel 120. The closed channel is adapted for guiding a fluid sample from an entrance, e.g. at the input well 110, to an exit, e.g. to a measurement chamber 150. The closed channel may comprise or may be connected to a storage room and/or reagent room and/or mixing room, although embodiments of the present invention are not limited thereby. In the closed channel optionally also a fluidic stop 160 may be present for preventing the fluid from spontaneously flowing more downstream the microfluidics device. According to embodiments of the present invention a hydrophilic coating 140 is applied to part of the walls of the closed channel, e.g. all of the walls of the fluidic closed channel being upstream a certain point in the microfluidics device. The part of the walls of the closed channel whereon a hydrophilic coating 140 is applied thereby first was treated so as to have an increased surface energy, shown as wall with increased surface energy 120, using an activation treatment such as a plasma treatment like plasma etching or UV radiation. The combination of the surface with increased surface energy and hydrophilic coating results in a more stable coating and in the possibility for better positioning the hydrophilic coating so that it is only present at desired positions, and does not influence other components of the system such as windows in the measurement room or fluidic stops. Application of hydrophilic coatings typically may result in obtaining a contact angle being smaller than 90°. In some embodiments, the hydrophilic coating may be selected such that a contact angle between 80° and 0° is obtained, e.g. between 40° and 80° or e.g. between 50° and 70°. Additional features for supplementary control of the flow, such as for example anti-wicking structures, also may be used. It is an advantage of embodiments according to the present invention that the application of the hydrophilic coating can be accurately spatially limited. The hydrophilic coating 140 may for example only be applied to the input well 110, and a part of the closed channel, such as for example in a storage chamber. The microfluidic device may be a multichannel device, comprising a plurality of channels in which characterisation can be performed independently. The microfluidic device may for example comprise at least 8 channels, at least 16 channels, at least 32 channels or at least 96 channels.

In one particular embodiment of the present invention, the closed channel comprises a storage chamber and the fluid inserted in the input well is spontaneously and immediately transferred to the storage chamber as soon as it is inserted. By transferring substantially all of the amount of fluid, there is meant at least 80% of the liquid received in the input well, more advantageously at least 90% of the liquid received in the input well. Spontaneous thereby in the present embodiment can be based on capillary forces, i.e. without the need for forces induced by an external source. According to embodiments of the present invention, "upon receipt of the amount of liquid in the input well" means that such spontaneous transfer may occur within a time span sufficiently short so that substantially no evaporation has occurred in the input well, e.g. a time span with an upper limit of 120 seconds from the moment the liquid is introduced in the input well, or more advantageously a time span with an upper limit of 60 seconds from the moment the liquid is introduced in the input well, still more advantageously a time span with an upper limit of 30 seconds or even more advantageous of 15 seconds from the moment the liquid is introduced in the input well. It is an advantage of embodiments according to the present invention that using the stable hydrophilic coating according to the present invention, an accurate and quick filling of the storage chamber can be obtained, resulting in good and reliable operation of such embodiments for several months or longer

By way of illustration, embodiments of the present invention not being limited thereto, some experimental results are further discussed. Artificially aged microfluidic chips were studied, whereby the coating was applied using plasma treatment in combination with provision of a wetting agent in the coated capillary channels. After several months heated storing at 60°, the microfluidic chips were still 100% self-filling without substantial loss in filling speed. The length of the coating in the capillary channels is, when measured after the effect of the plasma treatment has decreased substantially, defined by the amount of wetting liquid. With state-of-the-art liquid dispensers it is possible to dispense wetting agents with high repeatiblity and accuracy. This in contrast to the length of a hydrophilic treatment in a channel by plasma treatment, that depends on many process parameters and will show lower uniformity. In addition, plasma treated chips will very likely not reach 100% self-filling after several days, weeks or months, and will suffer slower filling speeds at sample loading.

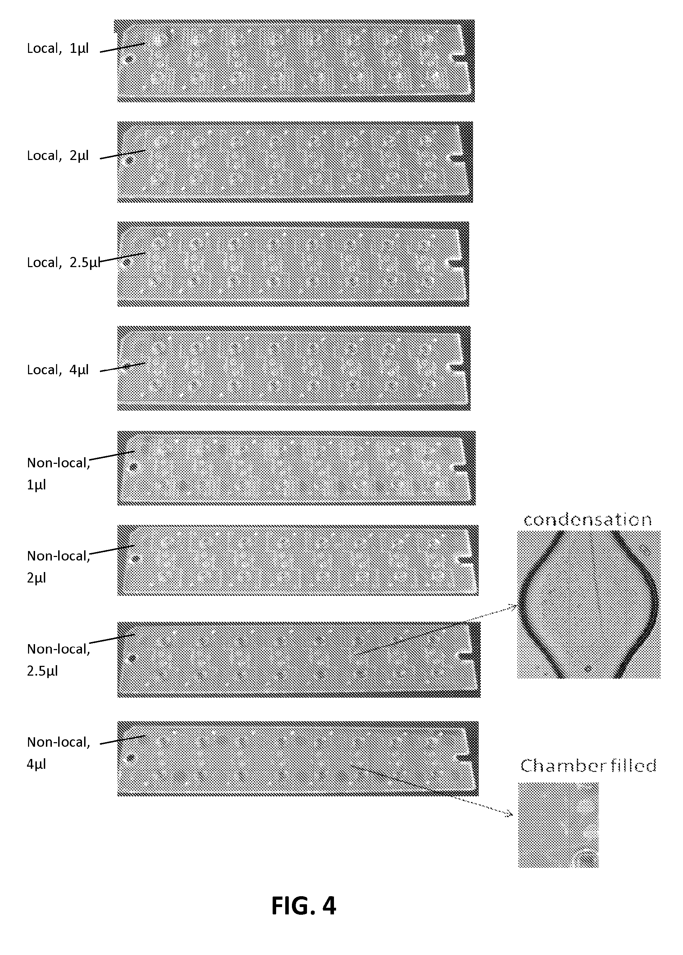

In addition, the dried wetting agent is capable of ensuring self-filling, even in the case of a non-smooth channel surface, small burrs etc. The effect of application of a hydrophilic coating using a method according to embodiments of the present invention in contrast to application of a hydrophilic coating by provision of a non-local treatment can be seen by the filling with fluid through the inlet. Filling of the microfluidic device via the inlet resulted in automated transfer of the sample to the hydrophilic coated portion of the channel for devices made according to embodiments of the present invention, whilst for devices provided with non-local treatment (e.g. plasma only), this resulted in condensation of sample in the measurement chamber (at 2.5µl) or unwanted filling of the measurement chamber (at 4µl). For smaller volumes (1µl and 2 µl) no effects were seen. The latter is illustrated in FIG. 4

In still another aspect, the present invention relates to a characterization system for characterizing a microfluidic sample, the system comprising a microfluidic device as described in the above embodiments. The system may further comprise conventional and optional components of a microfluidic characterization system as known in the prior art, such as for example a controller, an irradiation source, a pumping unit, a fluid introducing means, a detector or detection means, a processor, etc.

## Claims

1. A method (10) for obtaining a hydrophilic effect in a microfluidics device, the method comprising
- obtaining a microfluidics device (20) comprising a channel for transporting fluid from an entrance towards an exit,
- providing an activation treatment (40) to the obtained microfluidics device for increasing the surface energy of at least part of the walls of the channel at least at those positions where a hydrophilic effect is desirable, and
- thereafter selectively applying a coating (50) on selected parts of the walls of the channel by providing a predetermined amount of wetting agent in the channel.

2. A method (10) according to claim 1, wherein obtaining (20) a microfluidic device comprises obtaining (20) a microfluidics device comprising a closed channel for transporting fluid from an entrance towards an exit.

3. A method (10) according to any of claims 1 to 2, wherein providing (40) an activation treatment comprises applying plasma treatment (40).

4. A method (10) according to claim 3, wherein applying (40) plasma treatment comprises locally applying (40) plasma treatment for selectively increasing the surface energy of part of the walls of a channel.

5. A method (10) according to claim 4, wherein locally applying (40) plasma treatment comprises applying (40) plasma treatment to the channel via the entrance and/or exit of the microfluidics channel.

6. A method (10) according to any of claims 3 to 5, wherein applying plasma treatment comprises applying (40) an oxygen plasma etch.

7. A method (10) according to any of the previous claims, wherein providing an activation treatment (40) comprises irradiating the device using UV radiation.

8. A method (10) according to any of the previous claims, wherein providing (50) a predetermined amount of wetting agent in the channel comprises providing a polymer coating having a hydrophilic portion.

9. A method (10) according to the previous claim, wherein the polymer coating comprises ethylene oxide.

10. A method (10) according to claims 8 to 9, wherein the polymer coating comprises block copolymers based on ethylene oxide and propylene oxide.

11. A method (10) according to any of the previous claims, wherein the part of the walls where a hydrophilic effect is desirable comprises at least the entrance of the channel and a storage chamber for storing the fluidic sample before measurement.

12. A method (10) according to any of the previous claims, wherein obtaining (20) a microfluidics device comprising a channel for transporting fluids from an entrance towards an exit channel comprises obtaining (22) a moulded, embossed or casted first microfluidics device substrate forming at least a first part of the channel and providing (24) a top lid on the first microfluidics device substrate for closing the channel so as to form a closed channel.

13. A microfluidics device (100) for characterising a fluid sample, the microfluidics device (100) comprising a channel (120) for transporting fluid from an entrance towards an exit, the channel (120) being provided with a hydrophilic coating (140) on selected parts of the walls of the channel (120) using a method as described in claims 1 to 12.

14. A mircofluidics device (100) for characterising a fluid sample according to claim 13, wherein the channel (120) being a closed channel (120).
